# EUROPÄISCHE PATENTANMELDUNG

(11) **EP 2 129 202 A2**
(43) Veröffentlichungstag der Anmeldung: **02.12.2009**
(21) Anmeldenummer: 09161212.7
(22) Anmeldetag: 27.05.2009
(51) Int. Cl.: H05K 5/00

(54) **Verrastungskonstruktion**

(30) Priorität: 29.05.2008 DE 102008025754
(71) Anmelder: Gigaset Communications GmbH, 81379 München (DE)
(72) Erfinder: Höpken, Reiner, 46485, Wesel (DE); Kanders, Michael, 44795, Bochum (DE); Spiess, Oliver, 46395, Bocholt (DE)
(74) Vertreter: Michalski Hüttermann & Partner Patentanwälte

(57) **Zusammenfassung**

Es wird eine Verrastungskonstruktion vorgeschlagen, die eine Verkleinerung eines Gehäuses ermöglicht, durch die in der Nähe der Verrastungselemente angeordnete Bauteile wegen des Federwegs für die Verrastung verwendeter Federelemente (5) nicht beschädigt oder zerstört werden, durch die weiter eine Überdehnung der Federelemente (5) verhindert ist, und durch die es auch möglich ist, wenigstens eine zweier zusammengehöriger Gehäuseschalenhälften als metallisches Teil zu fertigen. Gelöst wird diese Aufgabe, indem eine Hintergreifkante (3) Teil einer an einer Innenseite (6) eines ersten Wandabschnitts (7) eines ersten Teils (1) angeordneten Nische (8) mit einer vorgegebenen Nischenform ist, und dass das Federelement (5) in einer Außenkontur (9) der Nischenform der Nische (8) eingepasst, im Verrastungszustand darin eingetaucht, einstückig mit einem zweiten Teil (2) verbunden und an einem torbogenartigen Teil (10) einseitig befestigt ist. Dabei ist ein freies Ende (11) des Federelements (5) bis neben einen Anschlag (12) ausgebildet.

## Beschreibung

Die Erfindung betrifft eine Verrastungskonstruktion gemäß dem Oberbegriff des Anspruchs 1.

Für die gegenseitige Verrastung eines ersten und eines zweiten Teils am Ende einer Verrastungsbewegung, die zum Beispiel ein Zusammenschieben des ersten und zweiten Teils ist, ist bekannt, an dem ersten Teil eine Hintergreifkante und an dem zweiten Teil ein eine Haltekante aufweisendes Federelement vorzusehen, dessen Haltekante im gegenseitigen Verrastungszustand des ersten und des zweiten Teils die besagte Hintergreifkante des ersten Teils hintergreift und dabei das erste und das zweite Teil miteinander verrastet hält.

Weiter ist bekannt, solche Verrastungskonstruktionen bei Gehäusen einzusetzen, die aus zwei Kunststoffteilen besteht.

Kunststoffteile haben den Vorteil, dass sie elastisch sind, so dass für die von Verrastungselementen benötigten Federwege auf die Verrastungselemente sowohl an dem einen Gehäuseteil als auch an dem anderen Gehäuseteil aufgeteilt werden können. Die Belastung für das einzelne Verrastungselement einer betreffenden Verrastungskonstruktion ist dadurch halbiert.

Auf der anderen Seite besteht das Problem, dass in einem betreffenden Gehäuse eingesetzte elektronische Bauteile, insbesondere empfindliche elektronische Bauteile, weit genug weg von den einzelnen Verrastungselementen platziert sind, so dass sie nicht auf Grund des von einem betreffenden Verrastungselement beanspruchten Federwegs beschädigt oder sogar zerstört werden können. Dabei ist insbesondere ein so großer Federweg zu berücksichtigen, dass es auch bei ungeplanten großen Krafteinwirkungen von außen, beispielsweise durch Fall eines zu Grunde liegenden elektrischen Geräts auf den Boden, zu keiner Beschädigung der besagten elektronischen Bauteile kommt.

Nachteilig hierbei ist, dass zu Grunde liegende elektronische Geräte vergrößert gebaut werden müssen, um Raum zu haben für die besagten Federwege. Weiter nachteilig ist, dass es dann auch möglich ist, die Verrastungselemente zu überdehnen und damit zu zerstören.

Das Überdehnungsproblem tritt insbesondere auch dann zu Tage, wenn eine von zwei Gehäuseschalenhälften beispielsweise statt aus elastischem Kunststoff aus einem unelastischen Metallmaterial besteht, weil dann der gesamte Federweg, also praktisch der doppelte Federweg, von demjenigen Verrastungselement abgedeckt werden muss, das mit dem elastischen Kunststoffgehäuseteil in Verbindung steht. Die Elastizität des metallischen Teils ist zu vernachlässigen und als starr zu betrachten.

Aufgabe der vorliegenden Erfindung ist es daher, ausgehend von einer Verrastungskonstruktion der eingangs genannten Art eine solche Verrastungskonstruktion in der Weise technisch zu verbessern, dass eine minimierte Bauweise für betreffende elektronische Geräte möglich ist, dass in der Nähe von betreffenden Verrastungselementen angeordnete empfindliche elektrische, elektronische oder sonstige Bauteile nicht wegen eines zu geringen Federwegs für die betreffenden Verrastungselemente beschädigt oder zerstört werden, dass betreffende Verrastungselemente vor einer Überdehnung geschützt sind, und dass nicht zwangsläufig alle verwendeten Gehäuseteile für ein Gehäuse für ein zu Grunde liegendes elektronischen Geräts aus elastischem Kunststoff bestehen müssen. Trotzdem soll die Verrastungskonstruktion eine einfache Bedienung bei der Verrastung zweier betreffender Teile ermöglichen und einfach bereit zu stellen sein.

Diese Aufgabe wird erfindungsgemäß durch eine Verrastungskonstruktion gelöst, die die Merkmale im kennzeichnenden Teil des Anspruchs 1 aufweist.

Eine solche Verrastungskonstruktion verhindert wegen des vorhandenen Anschlags für ein betreffendes Verrastungselement die Beschädigung oder Zerstörung von in der Nähe des betreffenden Verrastungselements platzierten elektrischen, elektronischen oder sonstigen Bauteilen.

Gleichzeitig können diese Bauteile wesentlich näher an die betreffenden Verrastungselemente heran platziert werden, wodurch in weiterer Folge ein zu Grunde liegendes elektronisches Gerät mit größerem Minimierungsgrad gebaut werden kann.

Außerdem sind die betreffenden Verrastungselemente durch den Anschlag vor einer Überdehnung geschützt.

Wegen des Überdehnungsschutzes und der Sicherheit vor Zerstörung beziehungsweise Beschädigung von betreffenden Bauteilen ist es nicht zwangsläufig nötig, alle verwendeten Gehäuseteile für ein Gehäuse für ein zu Grunde liegendes elektronisches Gerät aus elastischem Kunststoff zu fertigen. Es kann beispielsweise auch eines der betreffenden Gehäuseteile aus einem unelastischen metallischen Material bestehen.

Die Verrastungskonstruktion ermöglicht schließlich auch eine einfache Bedienung, die darin besteht, dass betreffende Gehäuseteile nur einfach zusammen zu schieben sind.

Ferner ist die Verrastungskonstruktion in einfacher Weise bereit zu stellen, weil eine betreffende Nische in dem einen der beiden verwendeten Teile durch Ausgestalten einer entsprechenden Gussform für die Herstellung dieses einen betreffenden Teils in einfacher Weise eingebracht werden kann, und weil auch das Federelement in dem anderen der beiden verwendeten Teile ohne Probleme gleich an das restliche Teil einstückig mit angegossen werden kann.

Vorteilhafte Ausgestaltungen der Erfindung sind Gegenstand von Unteransprüchen.

Danach sind ein erster und ein zweiter Wandabschnitt des betreffenden ersten Teils schräg nach außen verlaufend ausgebildet. Dies erleichtert das Einführen des betreffenden zweiten Teils in das erste Teil zwecks Verrastung der beiden Teile miteinander.

Eine Ausgestaltung der Außenkontur des Federelements als konische Komponente in der Weise, dass das Federelement in den ersten und zweiten Wandabschnitt des ersten Teils hineinlaufend ausgebildet ist, erleichtert das oben erwähnte Einführen des betreffenden zweiten Teils in das betreffende erste Teil zwecks Verrastung der beiden Teile miteinander zusätzlich.

Durch die Einbringung einer Aussparung in das betreffende zweite Teil ist es mit dem gleichen Teil auf einfache Weise möglich gemacht, den benötigten Anschlag für ein betreffendes Federelement ohne das Vorsehen weiterer Mittel zu Verfügung zu stellen.

Die Ausgestaltung des verwendeten torbogenartigen Teils als rahmenartiges Teil mit einer Mitte, an der das betreffende Federelement befestigt ist, bewirkt eine besonders stabile und wirksame Konstruktion des Federelements.

Vorteilhaft an der Ausgestaltung des ersten Teils als ein metallischer Gehäuserahmen ist, dass ein sich damit ergebendes Gehäuse für ein elektrisches oder elektronisches Gerät besonders stabil und darüber hinaus etwas Besonderes ist.

Ein anderer Vorteil der Verrastungskonstruktion ist, dass das betreffende zweite Teil ohne weiteres als ein Kunststoff-Gehäuse gefertigt sein kann.

Allgemein erklärt kann nochmals das Folgende gesagt werden.

Die Verrastungskonstruktion schützt benachbarte Bauelemente beziehungsweise Komponenten beim Einfedern der Verrastungskonstruktion vor Beschädigung. Solche Bauelemente beziehungsweise Komponenten sind oft zum Beispiel ein Displayglas oder auf einen Träger aufgelötete Bauelemente.

Weiterhin verhindert diese Bauart die Überdehnung des Federelements beziehungsweise des Rasthakens, der das Federelement letztlich ist. Die Überdehnung könnte ansonsten einen sogenannten Weißbruch oder einen Abriss insbesondere des für die Federung verantwortlichen Abschnitts des Federelements zur Folge haben.

Durch die besondere Gestaltung der Verrastungskonstruktion ist außerdem ein sehr guter Einführungswinkel zwischen dem ersten und dem zweiten Teil bei der Verrastung des ersten und des zweiten Teils bei der Gerätemontage gegeben.

Bei bisherigen Verrastungen bestanden beide miteinander zu verrastende Teile aus Kunststoff. Der Federweg konnte daher auf beide zu verrastenden Teile aufgeteilt werden. Ein Schutz benachbarter Bauteile bestand dabei nicht.

Bei der Verrastung taucht das zu verrastende zweite Teil vollständig in einen, zum Beispiel metallischen, Träger als ein erstes Teil ein. Die Elastizität des metallischen Trägers ist, wie oben schon gesagt, zu vernachlässigen und als starr zu betrachten. Somit muss der federnde Anteil der Verrastung im zweiten Teil, einem Kunststoffteil, den kompletten Federweg abfangen. Aus diesem Grund besteht, wie ebenfalls schon gesagt, die Gefahr, dass Bauelemente, die auf Grund eines geringen Bauvolumens und einer Führung nahe an der Gehäusewand platziert werden müssen, beim Einfedern des Federelements beziehungsweise des Rasthakens Schaden nehmen.

Die Verrastungskonstruktion ist außerdem grundsätzlich auch bei reinen Kunststoffverbindungen anwendbar.

Die Verrastung ist so angeordnet, dass der maximale Federweg unterhalb der gefährdeten Bauteile legt. Gleichzeitig sorgt ein Anschlag dafür, dass der Rasthaken bei der Montage oder bei Krafteinwirkungen von außen nicht vor das Bauteil drücken kann.

Nachfolgend wird ein Ausführungsbeispiel der Erfindung anhand einer Zeichnung näher erläutert. Darin zeigen:
- Figur 1: eine dreidimensionale Ansicht der erfindungsgemäßen Verrastungskonstruktion mit Blick auf einen Schnitt A-A gemäß der Figur 2,
- Figur 2: einen das Federelement gemäß der Figur 1 betreffenden Abschnitt des zweiten Teils der erfindungsgemäßen Verrastungskonstruktion in einer Ansicht von innen, und
- Figur 3: einen das Federelement gemäß der Figur 1 betreffenden Abschnitt des zweiten Teils der erfindungsgemäßen Verrastungskonstruktion in einer Ansicht von außen.

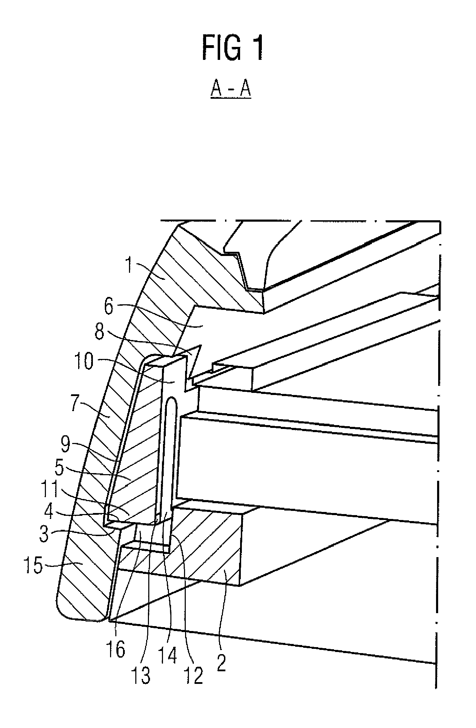

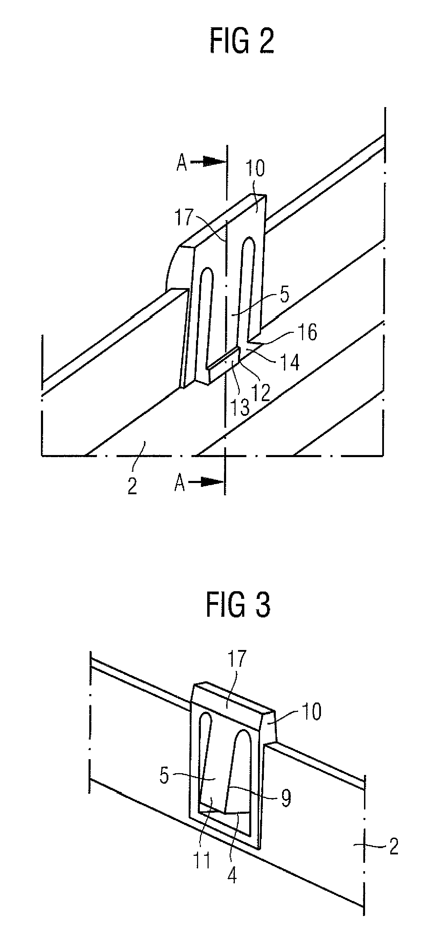

In den Figuren 1 bis 3 sind gleiche Teile mit dem gleichen Bezugszeichen versehen.

In den Figuren 1 bis 3, insbesondere in der Figur 1, ist eine Verrastungskonstruktion zwischen einem ersten 1 und einem zweiten 2 Teil für die gegenseitige Verrastung des ersten 1 und zweiten 2 Teils am Ende einer Verrastungsbewegung, die ein Zusammenschieben des ersten 1 und zweiten 2 Teils ist, zu sehen.

Das erste Teil 1 weist eine Hintergreifkante 3 auf.

Das zweite Teil 2 weist ein eine Haltekante 4 aufweisendes Federelement 5 auf.

Die Haltekante 4 hintergreift im gegenseitigen Verrastungszustand des ersten 1 und zweiten 2 Teils die besagte Hintergreifkante 3, wodurch das erste 1 und das zweite 2 Teil miteinander verrastet gehalten sind.

Die Hintergreifkante 3 ist Teil einer an einer Innenseite 6 eines ersten Wandabschnitts 7 des ersten Teils 1 angeordneten Nische 8 mit einer vorgegebenen Nischenform.

Das Federelement 5 weist eine Außenkontur 9 auf, die der Nischenform der Nische 8 eingepasst ist. Außerdem ist das Federelement 5 im gezeigten Verrastungszustand des ersten 1 und zweiten 2 Teils in die Nische 8 eingetaucht. Dabei hintergreift das Federelement 5 mit der Haltekante 4 die Hintergreifkante 3 der Nische 8.

Wie die Figuren 1 bis 3 zeigen, ist das Federelement 5 einstückig mit dem zweiten Teil 2 verbunden.

Das Federelement 5 ist an einem torbogenartigen Teil 10 des zweiten Teils 2 einseitig befestigt.

Ein freies Ende 11 des Federelements 5 ist bezüglich einer Ausweichbewegung des Federelements 5 beim Vorgang der Verrastung des ersten 1 und zweiten 2 Teils bis neben einen am zweiten Teil 2 ausgebildeten Anschlag 12 ausgebildet. Dabei bildet ein Bereich des dem Anschlag 12 gegenüberliegenden Teils des freien Endes 11 einen Gegenanschlag 13 für den Anschlag 12. Zwischen dem Anschlag 12 und dem Gegenanschlag 13 ist ein Freiraum 14 vorhanden in der Form, dass durch den Anschlag 13 ein Maß für die Ausweichbewegung des Federelements 5 voreingestellt begrenzt ist.

Die Innenseite 6 des ersten Teils 1 mit mehreren Wandabschnitten einschließlich des ersten Wandabschnitts 7 und die Außenkontur 9 des Federelements 5 sind in der Weise aufeinander abgestimmt geformt, dass bei der Verrastungsbewegung das Federelement 5 in einem ersten Zeitabschnitt von einem zweiten Wandabschnitt 15 des ersten Teils 1 übergriffen ist, in einem zweiten Zeitabschnitt von dem zweiten Wandabschnitt 15 zu einer Ausweichbewegung gezwungen ist, und in einem dritten Zeitabschnitt in die Nische 8 des ersten Wandabschnitts 7 eingetaucht ist.

Gemäß dem vorliegenden Ausführungsbeispiel sind der erste 7 und der zweite 15 Wandabschnitt schräg nach außen verlaufend ausgebildet.

Weiter ist gemäß dem vorliegenden Ausführungsbeispiel die Außenkontur 9 des Federelements 5 konisch in den ersten 7 und zweiten 15 Wandabschnitt des ersten Teils 1 hineinlaufend ausgebildet.

Außerdem ist der am zweiten Teil 2 ausgebildete Anschlag 12 Teil einer Aussparung 16.

Ferner ist gemäß dem vorliegenden Ausführungsbeispiel das torbogenartige Teil 10 rahmenartig ausgebildet mit einer Mitte 17, an der das Federelement 5 einstückig angeformt ist.

Zudem ist das erste Teil 1 ein metallischer Gehäuserahmen.

Zuletzt ist das zweite Teil 2 ein Kunststoff-Gehäuse.

## Patentansprüche

1. Verrastungskonstruktion zwischen einem ersten und einem zweiten Teil für die gegenseitige Verrastung des ersten und zweiten Teils am Ende einer Verrastungsbewegung, die ein Zusammenschieben des ersten und zweiten Teils ist, aufweisend an dem ersten Teil eine Hintergreifkante und weiter aufweisend an dem zweiten Teil ein eine Haltekante aufweisendes Federelement, dessen Haltekante im gegenseitigen Verrastungszustand des ersten und zweiten Teils die besagte Hintergreifkante hintergreift und dabei das erste und das zweite Teil miteinander verrastet hält, **dadurch gekennzeichnet, dass** die Hintergreifkante (3) Teil einer an einer Innenseite (6) eines ersten Wandabschnitts (7) des ersten Teils (1) angeordneten Nische (8) mit einer vorgegebenen Nischenform ist, dass das Federelement (5) in einer Außenkontur (9) der Nischenform der Nische (8) eingepasst und im Verrastungszustand des ersten (1) und zweiten (2) Teils unter mit der Haltekante (4) Hintergreifen der Hintergreifkante (3) der Nische (8) in die Nische (8) eingetaucht ist, dass das Federelement (5) einstückig mit dem zweiten Teil (2) verbunden ist, dass das Federelement (5) an einem torbogenartigen Teil (10) des zweiten Teils (2) einseitig befestigt ist, dass ein freies Ende (11) des Federelements (5) bezüglich einer Ausweichbewegung des Federelements (5) beim Vorgang der Verrastung des ersten (1) und zweiten (2) Teils bis neben einen am zweiten Teil (2) ausgebildeten Anschlag (12) ausgebildet ist in der Form, dass durch den Anschlag (12) ein Maß für die Ausweichbewegung voreingestellt begrenzt ist, und dass die Innenseite (6) von Wandabschnitten des ersten Teils (1) einschließlich des ersten Wandabschnitts (7) und die Außenkontur (9) des Federelements (5) in der Weise aufeinander abgestimmt geformt sind, dass bei der Verrastungsbewegung das Federelement (5) in einem ersten Zeitabschnitt von einem zweiten Wandabschnitt (15) des ersten Teils (1) übergriffen ist, in einem zweiten Zeitabschnitt von dem zweiten Wandabschnitt (15) zu einer Ausweichbewegung gezwungen ist, und in einem dritten Zeitabschnitt in die Nische (8) des ersten Wandabschnitts (7) eingetaucht ist.

2. Verrastungskonstruktion nach Anspruch 1, **dadurch gekennzeichnet, dass** erster (7) und zweiter (15) Wandabschnitt schräg nach außen verlaufend ausgebildet sind.

3. Verrastungskonstruktion nach Anspruch 1 oder 2, **dadurch gekennzeichnet, dass** die Außenkontur (9) des Federelements (5) konisch in den ersten (7) und zweiten (15) Wandabschnitt des ersten Teils (1) hineinlaufend ausgebildet ist.

4. Verrastungskonstruktion nach einem der vorherigen Ansprüche, **dadurch gekennzeichnet, dass** der am zweiten Teil (2) ausgebildete Anschlag (12) Teil einer Aussparung (16) ist.

5. Verrastungskonstruktion nach einem der vorherigen Ansprüche, **dadurch gekennzeichnet, dass** das torbogenartige Teil (10) rahmenartig ausgebildet ist mit einer Mitte (17), an der das Federelement (5) einstückig angeformt ist.

6. Verrastungskonstruktion nach einem der vorherigen Ansprüche, **dadurch gekennzeichnet, dass** das erste Teil (1) ein metallischer Gehäuserahmen ist.

7. Verrastungskonstruktion nach einem der vorherigen Ansprüche, **dadurch gekennzeichnet, dass** das zweite Teil (2) ein Kunststoff-Gehäuse ist.
